# EUROPEAN PATENT APPLICATION

(11) **EP 4 498 125 A1**
(43) Date of publication of application: **29.01.2025**
(21) Application number: 24154938.5
(22) Date of filing: 31.01.2024
(51) Int. Cl.: G01S 17/00, G06F 30/20, G06N 3/08, G06T 17/00, G06V 10/774, G06V 10/82

(54) **POINT CLOUD DATA GENERATION METHOD, APPARATUS, AND DEVICE, AND STORAGE MEDIUM**

(30) Priority: 24.07.2023 CN 202310916218
(71) Applicant: Chongqing Changan Automobile Co., Ltd., Chongqing 400023 (CN)
(72) Inventor: LONG, Pengyu, Jiangbei District, Chongqing, 400023 (CN); ZHENG, Bo, Jiangbei District, Chongqing, 400023 (CN); CHEN, Hao, Jiangbei District, Chongqing, 400023 (CN); ZHENG, Yuhang, Jiangbei District, Chongqing, 400023 (CN)
(74) Representative: M. Zardi & Co S.A.

(57) **Abstract**

Provided are a point cloud data generation method, apparatus, and device, and a storage medium, relating to the technical field of automobiles. The method includes: obtaining, by a point cloud data generation apparatus, a first panoramic depth map corresponding to a target viewing angle in a simulation system, where the target viewing angle is a viewing angle, which is used for simulating a laser radar deployed in a vehicle in a real environment, in the simulation system; and generating, according to simulation parameters of an object in the first panoramic depth map and the first panoramic depth map, a feature map corresponding to the target viewing angle, where feature data included in the feature map is used for indicating simulation parameters corresponding to pixel points included in the first panoramic depth map. Further, the point cloud data generation apparatus generates, according to the first panoramic depth map and the feature map, point cloud data corresponding to the target viewing angle. Thus, simulation of point cloud data generated by the laser radar in a simulation environment is achieved.

## Description

### Field of the Invention

The present application relates to the technical field of automobiles, and in particular, to the technical field of automatic driving, specifically to a point cloud data generation method, apparatus, and device, and a storage medium.

### Background of the Invention

With the development of an automatic driving technology, accurately identifying environments and objects around vehicles has become increasingly important. In an automatic driving algorithm, a laser radar is combined with other sensors (such as a camera, a radar, and an ultrasonic sensor) to provide multimodal perception. Data fusion of the various sensors can help an automatic driving system detect, track, and predict movements of surrounding objects more accurately.

Before the automatic driving algorithm is applied to real vehicle operation, it is usually tested in a simulation system. Therefore, the accuracy of each sensor in the simulation system will greatly affect the accuracy of a simulation test. In related technologies, the laser radar calculates a distance between an object and a sensor by emitting laser pulses and measuring time of reflection. In the simulation system, this process is usually simulated through Ray Casting. However, since materials and environments in the simulation system cannot completely correspond to those in a real world, it is hard to restore a scanning result of the laser radar, which affects the test on the automatic driving algorithm.

### Summary of the Invention

A first objective of the present application is to provide a point cloud data generation method, apparatus, and device, and a storage medium, to simulate, in a simulation environment, point cloud data generated by a laser radar.

In order to achieve the above objectives, the present application adopts the following technical solutions:
According to a first aspect of the present application, a point cloud data generation method is provided, including: obtaining, by a point cloud data generation apparatus, a first panoramic depth map corresponding to a target viewing angle in a simulation system, where the target viewing angle is a viewing angle, which is used for simulating a laser radar deployed in a vehicle in a real environment, in the simulation system; and inputting the first panoramic depth map and a feature map corresponding to the target viewing angle to a target model to generate the feature map corresponding to the target viewing angle, where feature data included in the feature map is used for indicating simulation parameters corresponding to pixel points included in the first panoramic depth map. Further, the point cloud data generation apparatus generates, according to the first panoramic depth map and the feature map, point cloud data corresponding to the target viewing angle.

According to the above technical means, in the point cloud data generation method provided in the present application, the target viewing angle that the same as a viewing angle of the laser radar deployed in the real environment is first obtained from the simulation system, and the first panoramic depth map of the target viewing angle is obtained. Further, the feature map corresponding to the target viewing angle is generated according to the simulation parameters of the object in the first panoramic depth map and the first panoramic depth map to achieve the generation of the point cloud data corresponding to the target viewing angle based on the first panoramic depth map and the feature map. The point cloud data is equivalent to point cloud data acquired by the laser radar in the simulation environment, so as to skip an operation of simulation of data acquisition by the laser radar the simulation laser radar. The point cloud data is generated directly according to information of the object included in the panoramic depth map, so that a material difference between the real environment and the simulation system is eliminated, and the accuracy of data required for a test on an automatic driving algorithm is guaranteed.

In a possible implementation, the feature map includes at least one of an incident angle feature map, a reflection coefficient feature map, a first motion vector feature map, and a second motion vector feature map; the feature data included in the incident angle feature map is used for indicating an incident angle corresponding to the pixel points included in the first panoramic depth map; the feature data included in the reflection coefficient feature map is used for indicating a reflection coefficient corresponding to the pixel points included in the first panoramic depth map; the feature data included in the first motion vector feature map is used for indicating a speed corresponding to the pixel points included in the first panoramic depth map at a first moment; the feature data included in the second motion vector feature map is used for indicating a speed corresponding to the pixel points included in the first panoramic depth map at a second moment; and the second moment is a moment later than the first moment.

In a possible implementation, in a case that the feature map includes the incident angle feature map, the generating, according to simulation parameters of an object in the first panoramic depth map and the first panoramic depth map, a feature map corresponding to the target viewing angle includes: determining incident angle data of the object according to a position corresponding to the target viewing angle and a position simulation parameter of the object, where the incident angle data of the object is used for characterizing an incident angle of laser emitted from the position corresponding to the target viewing angle to the object; and generating, according to the incident angle data of the object and a pixel coordinate system of the first panoramic depth map, the incident angle feature map corresponding to the target viewing angle, where each piece of feature data in the incident angle feature map is identified based on pixel coordinates.

According to the above technical means, the present application provides an implementation for generating the incident angle feature map, which provides a data support for the subsequent generation of the point cloud data corresponding to the target viewing angle.

In a possible implementation, in a case that the feature map includes the reflection coefficient feature map, the generating, according to simulation parameters of an object in the first panoramic depth map and the first panoramic depth map, a feature map corresponding to the target viewing angle includes: determining a reflection coefficient of the object according to a material simulation parameter of the object; and generating, according to the reflection coefficient of the object and a pixel coordinate system of the first panoramic depth map, the reflection coefficient feature map corresponding to the target viewing angle, where each piece of feature data in the reflection coefficient feature map is identified based on pixel coordinates.

According to the above technical means, the present application provides an implementation for generating the reflection coefficient feature map, which provides a data support for the subsequent generation of the point cloud data corresponding to the target viewing angle.

In a possible implementation, in a case that the feature map includes the first motion vector feature map, the generating, according to simulation parameters of an object in the first panoramic depth map and the first panoramic depth map, a feature map corresponding to the target viewing angle includes: generating, according to a speed simulation parameter of the object at the first moment and a pixel coordinate system of the first panoramic depth map, the first motion vector feature map corresponding to the target viewing angle, where each piece of feature data in the first motion vector feature map is identified based on pixel coordinates.

According to the above technical means, the present application provides an implementation for generating the first motion vector feature map, which provides a data support for the subsequent generation of the point cloud data corresponding to the target viewing angle.

In a possible implementation, in a case that the feature map includes the second motion vector feature map, the generating, according to simulation parameters of an object in the first panoramic depth map and the first panoramic depth map, a feature map corresponding to the target viewing angle includes: generating, according to a speed simulation parameter of the object at the second moment and a pixel coordinate system of the first panoramic depth map, the second motion vector feature map corresponding to the target viewing angle, where each piece of feature data in the second motion vector feature map is identified based on pixel coordinates.

According to the above technical means, the present application provides an implementation for generating the second motion vector feature map, which provides a data support for the subsequent generation of the point cloud data corresponding to the target viewing angle.

In a possible implementation, the inputting the first panoramic depth map and the feature map corresponding to the target viewing angle to a target model to generate point cloud data corresponding to the target viewing angle includes: inputting the first panoramic depth map and the feature map corresponding to the target viewing angle to the target model to obtain intensity information and depth information of a point cloud corresponding to the target viewing angle; and generating, according to the intensity information and depth information of the point cloud corresponding to the target viewing angle, the point cloud data corresponding to the target viewing angle.

According to the above technical means, the present application provides an implementation for generating the point cloud data corresponding to the target viewing angle according to the first panoramic depth map and the feature map, thus achieving the simulation of the point cloud data acquired by the laser radar without simulating the laser radar.

In a possible implementation, the point cloud data generation method further includes: obtaining operating data of a target vehicle in a first scenario, where the first scenario is a scenario in the real environment, and the operating data includes driving data of the target vehicle and real point cloud data acquired by a laser radar of the target vehicle; determining a second panoramic depth map and a feature map generated by a simulated vehicle driven with the driving data of the target vehicle in a second scenario, where the second scenario is a simulation scenario of the first scenario; and training a preset neural network by using the second panoramic depth map and the feature map as features and using the real point cloud data as a label to obtain the target model.

According to the above technical means, in the point cloud data generation method provided in the present application, model training features are obtained in a simulation scenario that is the same as the real environment, and a preset neural network is trained using a model training label obtained in the real environment, so as to simulate, in the simulation scenario, the point cloud data acquired by the laser radar.

According to a second aspect provided by the present application, a point cloud data generation apparatus is provided, including an obtaining unit and a generation unit. The obtaining unit is configured to obtain a first panoramic depth map corresponding to a target viewing angle in a simulation system, where the target viewing angle is a viewing angle, which is used for simulating a laser radar deployed in a vehicle in a real environment, in the simulation system. The generation unit is configured to generate, according to simulation parameters of an object in the first panoramic depth map and the first panoramic depth map, a feature map corresponding to the target viewing angle, where feature data included in the feature map is used for indicating simulation parameters corresponding to pixel points included in the first panoramic depth map. The generation unit is further configured to input the first panoramic depth map and the feature map corresponding to the target viewing angle to a target model to generate point cloud data corresponding to the target viewing angle.

In a possible implementation, the feature map includes at least one of an incident angle feature map, a reflection coefficient feature map, a first motion vector feature map, and a second motion vector feature map; the feature data included in the incident angle feature map is used for indicating an incident angle corresponding to the pixel points included in the first panoramic depth map; the feature data included in the reflection coefficient feature map is used for indicating a reflection coefficient corresponding to the pixel points included in the first panoramic depth map; the feature data included in the first motion vector feature map is used for indicating a speed corresponding to the pixel points included in the first panoramic depth map at a first moment; the feature data included in the second motion vector feature map is used for indicating a speed corresponding to the pixel points included in the first panoramic depth map at a second moment; and the second moment is a moment later than the first moment.

In a possible implementation, the point cloud data generation apparatus further includes a determination unit. In a case that the feature map includes the incident angle feature map, the determination unit is configured to determine incident angle data of the object according to a position corresponding to the target viewing angle and a position simulation parameter of the object, where the incident angle data of the object is used for characterizing an incident angle of laser emitted from the position corresponding to the target viewing angle to the object. The generation unit is specifically configured to generate, according to the incident angle data of the object and a pixel coordinate system of the first panoramic depth map, the incident angle feature map corresponding to the target viewing angle, where each piece of feature data in the incident angle feature map is identified based on pixel coordinates.

In a possible implementation, in a case that the feature map includes the reflection coefficient feature map, the determination unit is further configured to determine a reflection coefficient of the object according to a material simulation parameter of the object. The generation unit is specifically configured to generate, according to the reflection coefficient of the object and a pixel coordinate system of the first panoramic depth map, the reflection coefficient feature map corresponding to the target viewing angle, where each piece of feature data in the reflection coefficient feature map is identified based on pixel coordinates.

In a possible implementation, in a case that the feature map includes the first motion vector feature map, the generation unit is specifically configured to generate, according to a speed simulation parameter of the object at the first moment and a pixel coordinate system of the first panoramic depth map, the first motion vector feature map corresponding to the target viewing angle, where each piece of feature data in the first motion vector feature map is identified based on pixel coordinates.

In a possible implementation, in a case that the feature map includes the second motion vector feature map, the generation unit is specifically configured to generate, according to a speed simulation parameter of the object at the second moment and a pixel coordinate system of the first panoramic depth map, the second motion vector feature map corresponding to the target viewing angle, where each piece of feature data in the second motion vector feature map is identified based on pixel coordinates.

In a possible implementation, the point cloud data generation apparatus further includes a processing unit. The processing unit is configured to: input the first panoramic depth map and the feature map corresponding to the target viewing angle to the target model to obtain intensity information and depth information of a point cloud corresponding to the target viewing angle. The generation unit is specifically configured to generate, according to the intensity information and depth information of the point cloud corresponding to the target viewing angle, the point cloud data corresponding to the target viewing angle.

In a possible implementation, the obtaining unit is further configured to obtain operating data of a target vehicle in a first scenario, where the first scenario is a scenario in the real environment, and the operating data includes driving data of the target vehicle and real point cloud data acquired by a laser radar of the target vehicle. The determination unit is further configured to determine a second panoramic depth map and a feature map generated by a simulated vehicle driven with the driving data of the target vehicle in a second scenario, where the second scenario is a simulation scenario of the first scenario. The processing unit is further configured to: train a preset neural network by using the second panoramic depth map and the feature map as features and using the real point cloud data as a label to obtain the target model, where the target model is configured to simulate, on the basis of the panoramic depth maps and the feature maps obtained in the simulation environment, point cloud data generated by the laser radar.

According to a third aspect provided by the present application, a point cloud data generation device is provided. The point cloud data generation device includes a memory and a processor. The memory is coupled with the processor. The memory is configured to store computer program codes. The computer program codes include computer instructions. When the processor executes the computer instructions, the point cloud data generation device performs the point cloud data generation method provided according to the first aspect and any of the possible implementations described above.

According to a fourth aspect provided by the present application, a computer-readable storage medium is provided. The computer-readable storage medium stores instructions. When the instructions are run on a point cloud data generation device, the point cloud data generation device is caused to perform the point cloud data generation method provided according to the first aspect and any of the possible implementations described above.

According to a fifth aspect provided by the present application, a computer program product is provided. The computer program product includes computer instructions. When the computer instructions are run on a point cloud data generation device, the point cloud data generation device is caused to perform the point cloud data generation method provided according to the first aspect and any of the possible implementations described above.

Thus, the technical features of the present application have the following beneficial effects:
(1) In the point cloud data generation method provided in the present application, the target viewing angle that the same as a viewing angle of the laser radar deployed in the real environment is first obtained from the simulation system, and the first panoramic depth map of the target viewing angle is obtained. Further, the feature map corresponding to the target viewing angle is generated according to the simulation parameters of the object in the first panoramic depth map and the first panoramic depth map to achieve the generation of the point cloud data corresponding to the target viewing angle based on the first panoramic depth map and the feature map. The point cloud data is equivalent to point cloud data acquired by the laser radar in the simulation environment, so as to skip an operation of simulation of data acquisition by the laser radar the simulation laser radar. The point cloud data is generated directly according to information of the object included in the panoramic depth map, so that a material difference between the real environment and the simulation system is eliminated, and the accuracy of data required for a test on an automatic driving algorithm is guaranteed.
(2) In the point cloud data generation method provided in the present application, the model training features are obtained in the simulation scenario that is the same as the real environment, and the preset neural network is trained using the model training label obtained in the real environment, so as to simulate, in the simulation scenario, the point cloud data acquired by the laser radar.
(3) In the point cloud data generation method provided by the present application, the target model trained on the basis of the point cloud data generated by a real laser radar can better simulate a transmission effect of the laser radar on a light-transmittance material such as glass when simulating the generation of the point cloud data by the laser radar.
(4) In the point cloud data generation method provided in the present application, if the real laser radar is a multi-echo laser radar in the training process, the target model trained on the basis of point cloud data generated by the multi-echo laser radar can better simulate multiple mirror reflection and transmission effects when simulating the generation of the point cloud data by the multi-echo laser radar.

It should be noted that the technical effects achieved by any of the implementations in the second to fifth aspects can be found in the technical effects achieved by the implementation corresponding to the first aspect, and will not be elaborated here.

It should be understood that the foregoing general descriptions and the following detailed descriptions are merely for illustration and explanation purposes and are not intended to limit the present application.

### Brief Description of the Drawings

FIG. 1 is a schematic structural diagram of a point cloud data generation system shown according to an exemplary embodiment;
FIG. 2 is a flowchart of a point cloud data generation method shown according to an exemplary embodiment;
FIG. 3 is a flowchart of another point cloud data generation method shown according to an exemplary embodiment;
FIG. 4 is a flowchart of another point cloud data generation method shown according to an exemplary embodiment;
FIG. 5 is a block diagram of a point cloud data generation apparatus shown according to an exemplary embodiment; and
FIG. 6 is a block diagram of a point cloud data generation device shown according to an exemplary embodiment.

### Detailed Description of the Embodiments

The following will explain the implementations of the present application with reference to the accompanying drawings and preferred embodiments. Those skilled in the art can easily understand other advantages and effects of the present application from the content disclosed in the present application. The present application can also be implemented or applied through other different specific implementations, and the details in the present application can be modified or changed in various ways based on different perspectives and applications without departing from the spirit of the present application. It should be understood that the preferred embodiments are only intended to illustrate the present application and not intended to limit the protection scope of the present application.

It should be noted that the drawings provided in the following embodiments only schematically explain the basic concept of the present application. The drawings only show components related to the present application and are not drawn based on the quantities, shapes, and sizes of the components during actual implementation. The forms, quantities, and proportions of the components during actual implementation can be arbitrarily changed, and the layout of the components may also be more complex.

In the descriptions of the embodiments, unless otherwise stated, "/" represents "or", for example, A/B can be A or B. The term "and/or" herein only describes an association relationship for describing associated objects, representing that three relationships may exist. For example, A and/or B may represent three situations: A exists alone; A and B exist simultaneously; and B exists alone. In addition, "at least one" and "a plurality of' mean two or more. The terms "first", "second" and the like do not limit the quantity and execution order, and the terms "first", "second" and the like are not necessarily different.

Before the automatic driving algorithm is applied to real vehicle operation, it is usually tested in a simulation system. Therefore, the accuracy of each sensor in the simulation system will greatly affect the accuracy of a simulation test. In related technologies, the laser radar calculates a distance between an object and a sensor by emitting laser pulses and measuring time of reflection. In the simulation system, this process is usually simulated through Ray Casting. However, since materials and environments in the simulation system cannot completely correspond to those in a real world, it is hard to restore a scanning result of the laser radar, which affects the test on the automatic driving algorithm.

In order to solve the above problems, the present application provide a point cloud data generation method, apparatus, and device, and a storage medium. The point cloud data generation apparatus is configured to: obtain a first panoramic depth map corresponding to a target viewing angle in a simulation system, where the target viewing angle is a viewing angle, which is used for simulating a laser radar deployed in a vehicle in a real environment, in the simulation system; and generate, according to simulation parameters of an object in the first panoramic depth map and the first panoramic depth map, a feature map corresponding to the target viewing angle, where feature data included in the feature map is used for indicating simulation parameters corresponding to pixel points included in the first panoramic depth map. Further, the point cloud data generation apparatus generates, according to the first panoramic depth map and the feature map, point cloud data corresponding to the target viewing angle.

In this way, in the point cloud data generation method provided in the present application, the target viewing angle that the same as a viewing angle of the laser radar deployed in the real environment is first obtained from the simulation system, and the first panoramic depth map of the target viewing angle is obtained. Further, the feature map corresponding to the target viewing angle is generated according to the simulation parameters of the object in the first panoramic depth map and the first panoramic depth map to achieve the generation of the point cloud data corresponding to the target viewing angle based on the first panoramic depth map and the feature map. The point cloud data is equivalent to point cloud data acquired by the laser radar in the simulation environment, so as to skip an operation of simulation of data acquisition by the laser radar the simulation laser radar. The point cloud data is generated directly according to information of the object included in the panoramic depth map, so that a material difference between the real environment and the simulation system is eliminated, and the accuracy of data required for a test on an automatic driving algorithm is guaranteed.

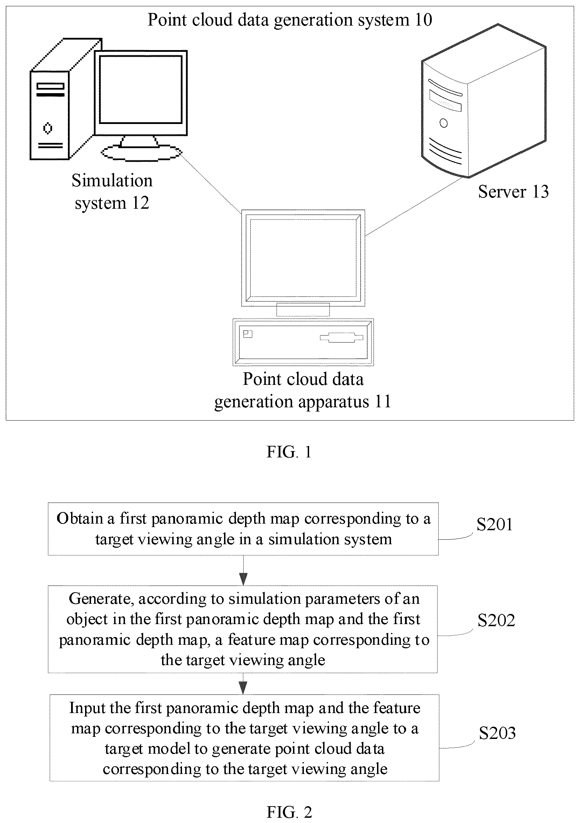

FIG. 1 shows a point cloud data generation system. A point cloud data generation method provided by the embodiments of the present application can be applicable to the point cloud data generation system as shown in FIG. 1 and is configured to achieve, in a simulation environment, simulation of point cloud data generated by a laser radar. As shown in FIG. 1, the point cloud data generation system 10 includes a point cloud data generation apparatus 11, a simulation system 12, and a server 13.

The point cloud data generation apparatus 11 is connected to the simulation system 12 and the server 13 respectively. In the above connection relationships, wired or wireless connection can be used. The embodiments of the present application do not limit this.

The point cloud data generation apparatus 11 can be used in the simulation system to obtain a first panoramic depth map corresponding to a target viewing angle.

The target viewing angle is used for simulating, in the simulation system, a viewing angle of a laser radar deployed on a vehicle in a real environment.

The point cloud data generation apparatus 11 can also be configured to generate a feature map corresponding to the target viewing angle according to simulation parameters of an object in the first panoramic depth map and the first panoramic depth map.

Feature data included in the feature map is used for indicating simulation parameters corresponding to pixel points included in the first panoramic depth map.

The point cloud data generation apparatus 11 can also be configured to generate, according to the first panoramic depth map and the feature map, point cloud data corresponding to the target viewing angle.

The simulation system 12 can be a system which is deployed by operation and maintenance personnel of the point cloud data generation system 10 on the basis of environment data, object data, vehicle driving data, and the like acquired in the real environment, and is configured to test simulated automatic driving of the vehicle.

The server 13 can be configured to store the point cloud data generated by the point cloud data generation apparatus 11, store simulation parameters of the simulation system 12, and store the acquired data from the real environment.

FIG. 2 is a flowchart of a point cloud data generation method shown according to some exemplary embodiments. In some embodiments, the point cloud data generation method described above can be applied to the point cloud data generation apparatus 11 in the point cloud data generation system 10 shown in FIG. 1. The embodiments of the present application take application of the point cloud data generation method to the point cloud data generation apparatus 11 as an example to explain the point cloud data generation method described above.

As shown in FIG. 2, the point cloud data generation method provided in the embodiments of the present application includes following S201 to S203.

In S201, a point cloud data generation apparatus obtains a first panoramic depth map corresponding to a target viewing angle in a simulation system.

The target viewing angle is a viewing angle, which is used for simulating a laser radar deployed in a vehicle in a real environment, in the simulation system.

As a possible implementation, the point cloud data generation apparatus simulates a position of a laser radar of a real environment in the simulation system on the basis of a pre-constructed simulation system, and uses the target viewing angle that is the same as the viewing angle of the laser radar in the real environment to generate the first panoramic depth map in a manner of rendering a three-dimensional mode in a rendering pipeline.

It should be noted that the simulation environment of the simulation system is arranged on the basis of a scenario in the real environment in advance, where a plurality of objects are deployed, including buildings, vegetations, vehicles, pedestrians, road surfaces, signs, and traffic lights. In order to improve the realism of the simulation environment, corresponding materials and textures are assigned to the objects in the simulation environment on the basis of materials and textures of the various objects in the real-life environment. Furthermore, the various objects are assigned with the same motion directions and velocities as those in the real environment to ensure the accuracy of subsequently obtained point cloud data.

It should be noted that in the first panoramic depth map corresponding to the target viewing angle and obtained by the point cloud data generation apparatus, a vertical viewing angle is the same as a vertical viewing angle of the laser radar, and a horizontal viewing angle is a 360-degree panoramic viewing angle.

It can be understood that since the scenario at the target viewing angle in the simulation system is photographed at the target viewing angle that is the same as the viewing angle of the laser radar deployed on the vehicle in the real environment, to obtain the first panoramic depth map, so that all the objects scanned by the laser radar can be contained in the first panoramic depth map to ensure the integrality of point cloud data generated in the subsequent process.

In S202, the point cloud data generation apparatus generates, according to simulation parameters of an object in the first panoramic depth map and the first panoramic depth map, a feature map corresponding to the target viewing angle.

Feature data included in the feature map is used for indicating simulation parameters corresponding to pixel points included in the first panoramic depth map.

As a possible implementation, the point cloud data generation apparatus determines objects corresponding to various pixel points in the first panoramic image depth map, and determines simulation parameters of the corresponding objects. Further, the point cloud data generation apparatus determines a pixel coordinate of each pixel point in a pixel coordinate system in the first panoramic depth map. Finally, the point cloud data generation apparatus generates, according to the simulation parameter and pixel coordinate corresponding to each pixel point, a feature map corresponding to the target viewing angle.

It should be noted that one representation form of the feature map can be a two-dimensional array. A quantity of rows of the two-dimensional array is a maximum value of vertical pixel coordinates in the first panoramic depth map, and a quantity of columns of the two-dimensional array is a maximum value of horizontal pixel coordinates in the first panoramic depth map. Each element in the two-dimensional array stores the pixel point and simulation parameter corresponding to the element, and the feature map corresponding to the target viewing angle is obtained.

In some embodiments, the feature map includes at least one of an incident angle feature map, a reflection coefficient feature map, a first motion vector feature map, and a second motion vector feature map.

The feature data included in the incident angle feature map is used for indicating an incident angle corresponding to the pixel points included in the first panoramic depth map; the feature data included in the reflection coefficient feature map is used for indicating a reflection coefficient corresponding to the pixel points included in the first panoramic depth map; the feature data included in the first motion vector feature map is used for indicating a speed corresponding to the pixel points included in the first panoramic depth map at a first moment; the feature data included in the second motion vector feature map is used for indicating a speed corresponding to the pixel points included in the first panoramic depth map at a second moment; and the second moment is a moment later than the first moment.

In an example, in a case that the feature map is the incident angle feature map, the point cloud data generation apparatus generates, according to simulation parameters of an object in the first panoramic depth map and the first panoramic depth map, a feature map corresponding to the target viewing angle, which includes:
The point cloud data generation apparatus determines incident angle data of the object according to a position corresponding to the target viewing angle and a position simulation parameter of the object, where the incident angle data of the object is used for characterizing an incident angle of laser emitted from the position corresponding to the target viewing angle to the object; and generating, according to the incident angle data of the object and a pixel coordinate system of the first panoramic depth map, the incident angle feature map corresponding to the target viewing angle, where each piece of feature data in the incident angle feature map is identified based on pixel coordinates.

As a possible implementation, the point cloud data generation apparatus determines a direction vector from the position corresponding to the target viewing angle to the position of the object according to the position corresponding to the target viewing angle and the position simulation parameter of the object, and further obtains a normal vector of an object surface of the object in the simulation environment, thus determining the incident angle data of the object according to the direction vector and the normal vector. Further, the point cloud data generation apparatus fills corresponding elements in the two-dimensional array with the incident angle data according to the pixel coordinates of the pixel points corresponding to the object in the first panoramic depth map. After the elements, corresponding to all the pixel points in the first panoramic depth map, in the two-dimensional array are filled with the feature data, the incident angle feature map corresponding to the target viewing angle is obtained.

In another example, in a case that the feature map is the reflection coefficient feature map, the point cloud data generation apparatus generates, according to simulation parameters of an object in the first panoramic depth map and the first panoramic depth map, a feature map corresponding to the target viewing angle, which includes:
The point cloud data generation apparatus determines a reflection coefficient of the object according to a material simulation parameter of the object, and generates, according to the reflection coefficient of the object and a pixel coordinate system of the first panoramic depth map, the reflection coefficient feature map corresponding to the target viewing angle, where each piece of feature data in the reflection coefficient feature map is identified based on pixel coordinates.

As a possible implementation, the point cloud data generation apparatus determines the reflection coefficient of the object according to the material simulation parameter of the object and a mapping relationship between a material and the reflection coefficient. Further, the point cloud data generation apparatus fills corresponding elements in the two-dimensional array with the reflection coefficient of the object according to the pixel coordinates of the pixel points corresponding to the object in the first panoramic depth map. After the elements, corresponding to all the pixel points in the first panoramic depth map, in the two-dimensional array are filled with the feature data, the reflection coefficient feature map corresponding to the target viewing angle is obtained.

It should be noted that the reflection coefficient is used for characterizing a reflectivity of the material to the laser emitted by the laser radar. The mapping relationship between the material and the reflection coefficient can be set by operation and maintenance personnel of the point cloud data generation system in advance in the point cloud data generation apparatus. The embodiments of the present application will not specifically limit this.

In some embodiments, materials of some objects are not exactly the same. For example, a vegetation includes different materials such as a trunk, leaves, and flowers, vehicles are made of different materials such as metal and plastic, and road surfaces include hardened road surfaces, soil lands, and the like. Therefore, during the determination of the reflection coefficient of the object corresponding to each pixel point, the point cloud data generation apparatus determines, according to the position of the object corresponding to a first pixel point, the material assigned to the position and then determines, according to the material assigned to the position, a reflection coefficient corresponding to the first pixel point, so that the determined reflection coefficient feature map is more accurate.

In another example, in a case that the feature map is the first motion vector feature map, the point cloud data generation apparatus generates, according to simulation parameters of an object in the first panoramic depth map and the first panoramic depth map, a feature map corresponding to the target viewing angle, which includes:
The point cloud data generation apparatus generates, according to a speed simulation parameter of the object at the first moment and a pixel coordinate system of the first panoramic depth map, the first motion vector feature map corresponding to the target viewing angle, where each piece of feature data in the first motion vector feature map is identified based on pixel coordinates.

As a possible implementation, the point cloud data generation apparatus fills corresponding elements in the two-dimensional array with a speed of the object at the first moment according to the pixel coordinates corresponding to the object in the first panoramic depth map. After the elements, corresponding to all the pixel points in the first panoramic depth map, in the two-dimensional array are filled with the feature data, the first motion vector feature map corresponding to the target viewing angle is obtained.

In some embodiments, speeds of various parts of some objects at the first moment are not exactly the same. For example, in a case that a speed of a tree trunk of a vegetation is 0, a speed of a leaf is not 0, or both the tree trunk and the leaf have speeds, but due to the fact that they are different materials, speed simulation parameters configured for the them are also different. Therefore, the point cloud data generation apparatus first determines a part of the object corresponding to the first pixel point in the first panoramic depth map and then determines, according to the speed simulation parameter configured for the part of the object at the first moment, the speed corresponding to the first pixel point at the first moment, so that the determined first motion vector feature map is more accurate.

In another example, in a case that the feature map is the second motion vector feature map, the point cloud data generation apparatus generates, according to simulation parameters of an object in the first panoramic depth map and the first panoramic depth map, a feature map corresponding to the target viewing angle, which includes:
The point cloud data generation apparatus generates, according to a speed simulation parameter of the object at the second moment and a pixel coordinate system of the first panoramic depth map, the second motion vector feature map corresponding to the target viewing angle, where each piece of feature data in the second motion vector feature map is identified based on pixel coordinates.

It should be noted that the specific implementation of generating, by the point cloud data generation apparatus, the second motion vector feature map can refer to the implementation of generating the first motion vector feature map in the embodiment described above, as long as the speed at the first moment is changed to the speed at the second moment. This will not be elaborated here.

In S203, the point cloud data generation apparatus inputs the first panoramic depth map and the feature map corresponding to the target viewing angle to a target model to generate point cloud data corresponding to the target viewing angle.

As a possible implementation, the point cloud data generation apparatus generates, on the basis of the first panoramic depth map obtained in step S201 described above, the feature map generated in step S202 described above, and the feature data corresponding to each pixel point in the first panoramic depth map, the point cloud data corresponding to the target viewing angle according to a manner of processing the acquired data by the laser radar.

As another possible implementation, the point cloud data generation apparatus inputs the first panoramic depth map obtained in step S201 described above and the feature map corresponding to the target viewing angle and generated in step S202 described above to the target model to obtain the intensity information and depth information of the point cloud corresponding to the target viewing angle. Further, the point cloud data generation apparatus combines the intensity information of the point cloud with the depth information of the point cloud according to the intensity information and depth information of the point cloud corresponding to the target viewing angle to generate the point cloud data corresponding to the target viewing angle.

It should be noted that the target model is used for generating and outputting, on the basis of the input panoramic depth map and feature map corresponding to the target viewing angle, the point cloud data corresponding to the target viewing angle. Details of training the target model can refer to subsequent descriptions of the embodiments of the present application.

In some embodiments, the point cloud data generation apparatus stores the point cloud data on the basis of a preset format after generating the point cloud data corresponding to the target viewing angle. For example, the preset format can be .pcb or the like.

It can be understood that in the point cloud data generation method provided in the embodiment described above of the present application, the target viewing angle that the same as a viewing angle of the laser radar deployed in the real environment is first obtained from the simulation system, and the first panoramic depth map of the target viewing angle is obtained. Further, the feature map corresponding to the target viewing angle is generated according to the simulation parameters of the object in the first panoramic depth map and the first panoramic depth map to achieve the generation of the point cloud data corresponding to the target viewing angle based on the first panoramic depth map and the feature map. The point cloud data is equivalent to point cloud data acquired by the laser radar in the simulation environment, so as to skip an operation of simulation of data acquisition by the laser radar the simulation laser radar. The point cloud data is generated directly according to information of the object included in the panoramic depth map, so that a material difference between the real environment and the simulation system is eliminated, and the accuracy of data required for a test on an automatic driving algorithm is guaranteed. Furthermore, the target model is trained on the basis of the point cloud data generated by a real laser radar, so that a transmission effect of the laser radar on a light-transmittance material such as glass is better simulated.

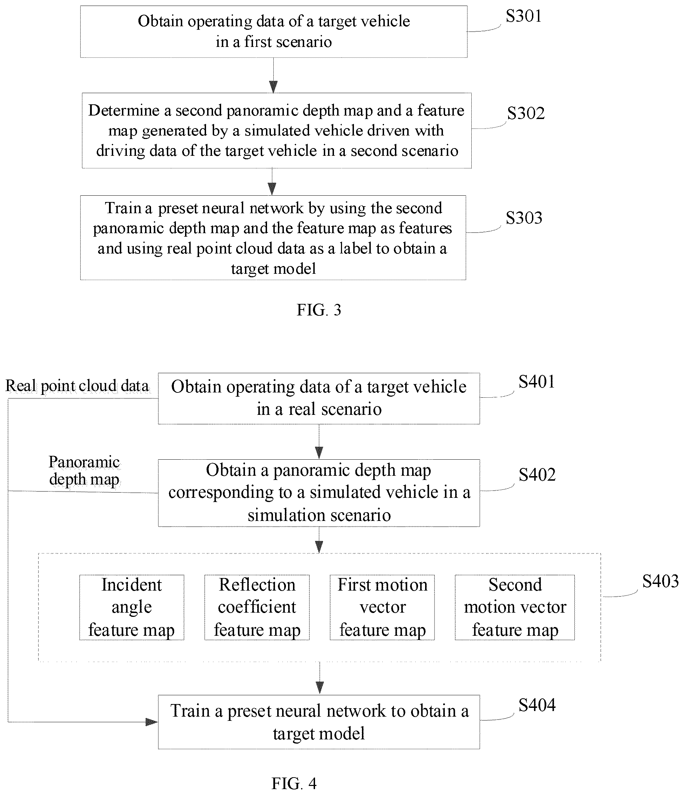

In a design, in order to obtain the target model, the point cloud data generation method provided by the embodiments of the present application, as shown in FIG. 3, further includes S301 to S303.

In S301, the point cloud data generation apparatus obtains operating data of a target vehicle in a first scenario.

The first scenario is a scenario in the real environment, and the operating data includes driving data of the target vehicle and real point cloud data acquired by a laser radar of the target vehicle.

As a possible implementation, the target vehicle is deployed with the laser radar. In a driving process, the target vehicle reports real point cloud data acquired by the laser radar and driving data in the driving process to the server through an in-vehicle infotainment.

Correspondingly, the point cloud data generation apparatus obtains, on the basis of an identifier of the target vehicle from the server, the operating data reported by the target vehicle to obtain the driving data and real point cloud data of the target vehicle.

In S302, the point cloud data generation apparatus determines a second panoramic depth map and a feature map generated by a simulated vehicle driven with the driving data of the target vehicle in a second scenario,
where the second scenario is a simulation scenario of the first scenario.

As a possible implementation, the point cloud data generation apparatus obtains, in the second scenario according to the implementation shown in step S201 described above, the second panoramic depth map obtained by driving the simulated vehicle with the driving data of the target vehicle, and generates, according to the implementation shown in Step S202 described above, the feature map corresponding to the target viewing angle of the simulated vehicle in a case that the simulated vehicle is driven with the driving data of the target vehicle.

It should be noted that a specific implementation of generating, by the point cloud data generation apparatus, the second panoramic depth map and the feature map can refer to the descriptions of step S201 and step S202 in the embodiment described above of the present application, and will not be elaborated here.

In some embodiments, the second scenario can be built by the operation and maintenance personnel of the point cloud data generation system and is called by the point cloud data generation apparatus. Pictures of the first scenario captured by a plurality of camera sensors on the vehicle and the point cloud data acquired by the laser radar on the target vehicle when the target vehicle is operated in the first scenario are obtained, thus obtaining a plurality of objects in the first scenario. Further, the operation and maintenance personnel of the point cloud data generation system builds the second scenario according to the pictures of the first scenario and the point cloud data of the plurality of objects in the first scenario.

Exemplarily, a building process of the second scenario includes: modeling the plurality of objects to obtain three-dimensional models of the plurality of objects. Further, materials and textures are assigned to the three-dimensional models of the plurality of objects according to materials and textures of the plurality of objects in the real environment. Further, according to motion conditions of the plurality of objects in the real environment, the plurality of objects are configured with motion directions and speeds that are the same as those in the real environment.

In S303, the point cloud data generation apparatus trains a preset neural network by using the second panoramic depth map and the feature map as features and using the real point cloud data as a label to obtain the target model.

As a possible implementation, the point cloud data generation apparatus performs supervised training on the preset neural network on the basis of the second panoramic depth map and the feature map which serve as the features, and the real point cloud data serving as the label, to generate the target model.

It should be noted that in the process of training the preset neural network, in order to ensure the accuracy of the target model, the preset neural network is trained on the basis of a plurality of groups of second panoramic depth maps, feature maps, and real point cloud data.

The preset neural network can be set by the operation and maintenance personnel of the point cloud data generation system in advance in the point cloud data generation apparatus. Exemplarily, the preset neural network can be a convolutional neural network (CNN), which includes at least two groups of convolution kernels. Each group of convolution kernels includes five convolution kernels. Deep information of the second panoramic depth map and deep information of the feature map can be obtained by downsampling, so that the intensity information and depth information of the point cloud can be obtained by upsampling.

In some embodiments, input data of the preset neural network is a two-dimensional array with five channels, and output data is a two-dimensional array with two channels. The input data includes the second panoramic depth map, the incident angle feature map, the reflection coefficient feature map, the first motion vector feature map, and the second motion vector feature map. The output data includes an intensity of the point cloud and a depth of the point cloud.

In some embodiments, the point cloud data generation apparatus combines the intensity of the point cloud with the depth of the point cloud after the preset neural network outputs the intensity of the point cloud and the depth of the point cloud, to obtain training point could data. Further, a cross entropy of the training point cloud data and the real point cloud data is determined. The training point cloud data is output in a case that the cross entropy is less than a preset cross entropy.

In some embodiments, if the laser radar deployed on the target vehicle is a multi-echo laser radar, the target model is trained by taking point cloud data acquired by the multi-echo laser radar as a label. In this way, it is possible to better simulate multiple mirror reflection and transmission effects during the simulation of the generation of the point cloud data by the multi-echo laser radar through the target model.

It can be understood that in the point cloud data generation method provided by the embodiments described above of the present application, the model training features are obtained in the simulation scenario that is the same as the real environment, and the preset neural network is trained using the model training label obtained in the real environment, so as to simulate, in the simulation scenario, the point cloud data acquired by the laser radar.

In one design, in combination with the embodiments described above of the present application, the point cloud data generation method provided in the embodiments of the present application, as shown in FIG. 4, includes S401 to S404.

In S401, the point cloud data generation apparatus obtains operating data of a target vehicle in a real scenario.

In S402, the point cloud data generation apparatus obtains a panoramic depth map corresponding to a simulated vehicle in a simulation scenario.

In S403, the point cloud data generation apparatus generates, on the basis of the panoramic depth map, an incident angle feature map, a reflection coefficient feature map, a first motion vector feature map, and a second motion vector feature map corresponding to the panoramic depth map.

In S404, the point cloud data generation apparatus trains a preset neural network to obtain a target model.

The point cloud data generation apparatus inputs the panoramic depth map, the incident angle feature map, the reflection coefficient feature map, the first motion vector feature map, the second motion vector feature map, and the real point cloud data to the preset neural network to train the preset neural network.

It should be noted that a specific implementation of the point cloud data generation method described in step S401 to step S404 described above can refer to the descriptions in the embodiments described above of the present application, and will not be elaborated here.

The above mainly introduces the solutions provided by the embodiments of the present application from the perspective of view of a method. In order to achieve the above functions, the point cloud data generation apparatus or point cloud data generation device includes corresponding hardware structures and/or software modules configured to execute the various functions. A person skilled in the art should easily realize that the present application can be implemented in the form of hardware or a combination of hardware and computer software in combination with units and algorithm steps of the various examples described in the embodiments disclosed herein. Whether a function is implemented in hardware or in a manner of driving hardware by computer software depends on particular applications and design constraint conditions of the technical solutions. A person skilled in the art may use different methods to implement the described functions for each particular application, but it should not be considered that the implementation goes beyond the scope of the present application.

The embodiments of the present application can exemplarily divide functional modules of the point cloud data generation apparatus or the point cloud data generation device. For example, the point cloud data generation apparatus or the point cloud data generation device may include various functional modules corresponding to various functional divisions, or two or more functions may be integrated into one processing module. The integrated module may be implemented in a form of hardware, or may be implemented in a form of a software functional module. It should be noted that in this embodiment of the present application, division into the modules is an example and is merely logical function division, and may be other division in an actual implementation.

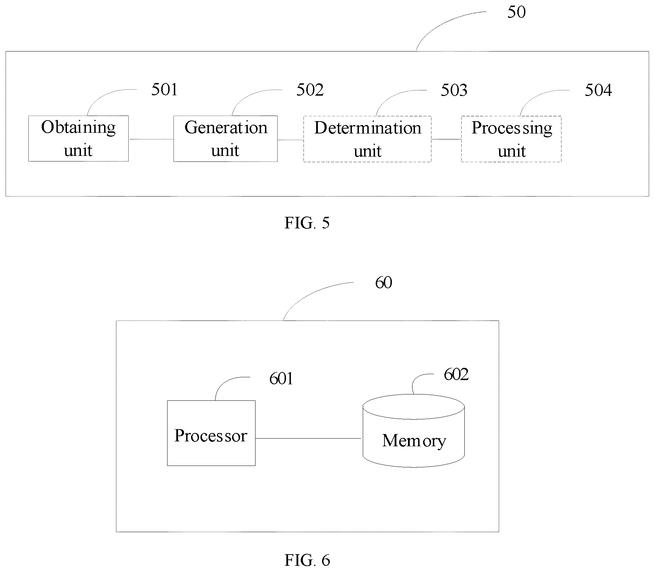

FIG. 5 is a schematic structural diagram of a point cloud data generation apparatus according to an embodiment of the present application. The point cloud data generation apparatus is configured to perform the point cloud data generation method described above. As shown in FIG. 5, the point cloud data generation apparatus 50 includes an obtaining unit 501 and a generation unit 502.

The obtaining unit 501 is configured to obtain a first panoramic depth map corresponding to a target viewing angle in a simulation system, where the target viewing angle is a viewing angle, which is used for simulating a laser radar deployed in a vehicle in a real environment, in the simulation system.

The generation unit 502 is configured to generate, according to simulation parameters of an object in the first panoramic depth map and the first panoramic depth map, a feature map corresponding to the target viewing angle, where feature data included in the feature map is used for indicating simulation parameters corresponding to pixel points included in the first panoramic depth map.

The generation unit 502 is further configured to input the first panoramic depth map and the feature map to a target model to generate point cloud data corresponding to the target viewing angle.

Optionally, the feature map includes at least one of an incident angle feature map, a reflection coefficient feature map, a first motion vector feature map, and a second motion vector feature map; the feature data included in the incident angle feature map is used for indicating an incident angle corresponding to the pixel points included in the first panoramic depth map; the feature data included in the reflection coefficient feature map is used for indicating a reflection coefficient corresponding to the pixel points included in the first panoramic depth map; the feature data included in the first motion vector feature map is used for indicating a speed corresponding to the pixel points included in the first panoramic depth map at a first moment; the feature data included in the second motion vector feature map is used for indicating a speed corresponding to the pixel points included in the first panoramic depth map at a second moment; and the second moment is a moment later than the first moment.

Optionally, the point cloud data generation apparatus 50 further includes a determination unit 503. In a case that the feature map includes the incident angle feature map, the determination unit 503 is configured to determine incident angle data of the object according to a position corresponding to the target viewing angle and a position simulation parameter of the object, where the incident angle data of the object is used for characterizing an incident angle of laser emitted from the position corresponding to the target viewing angle to the object.

The generation unit 502 is specifically configured to generate, according to the incident angle data of the object and a pixel coordinate system of the first panoramic depth map, the incident angle feature map corresponding to the target viewing angle, where each piece of feature data in the incident angle feature map is identified based on pixel coordinates.

Optionally, in a case that the feature map includes the reflection coefficient feature map, the determination unit 503 is further configured to determine a reflection coefficient of the object according to a material simulation parameter of the object.

The generation unit 502 is specifically configured to generate, according to the reflection coefficient of the object and a pixel coordinate system of the first panoramic depth map, the reflection coefficient feature map corresponding to the target viewing angle, where each piece of feature data in the reflection coefficient feature map is identified based on pixel coordinates.

Optionally, in a case that the feature map includes the first motion vector feature map, the generation unit 502 is specifically configured to generate, according to a speed simulation parameter of the object at the first moment and a pixel coordinate system of the first panoramic depth map, the first motion vector feature map corresponding to the target viewing angle, where each piece of feature data in the first motion vector feature map is identified based on pixel coordinates.

Optionally, in a case that the feature map includes the second motion vector feature map, the generation unit 502 is specifically configured to generate, according to a speed simulation parameter of the object at the second moment and a pixel coordinate system of the first panoramic depth map, the second motion vector feature map corresponding to the target viewing angle, where each piece of feature data in the second motion vector feature map is identified based on pixel coordinates.

Optionally, the point cloud data generation apparatus 50 further includes a processing unit 504.

The processing unit 504 is configured to: input the first panoramic depth map and the feature map corresponding to the target viewing angle to the target model to obtain intensity information and depth information of a point cloud corresponding to the target viewing angle.

The generation unit 502 is specifically configured to generate, according to the intensity information and depth information of the point cloud corresponding to the target viewing angle, the point cloud data corresponding to the target viewing angle.

Optionally, the obtaining unit 501 is further configured to obtain operating data of a target vehicle in a first scenario, where the first scenario is a scenario in the real environment, and the operating data includes driving data of the target vehicle and real point cloud data acquired by a laser radar of the target vehicle.

The determination unit 503 is further configured to determine a second panoramic depth map and a feature map generated by a simulated vehicle driven with the driving data of the target vehicle in a second scenario, where the second scenario is a simulation scenario of the first scenario.

The processing unit 504 is further configured to train a preset neural network by using the second panoramic depth map and the feature map as features and using the real point cloud data as a label to obtain the target model.

FIG. 6 is a block diagram of a point cloud data generation device shown according to an exemplary embodiment. As shown in FIG. 6, the point cloud data generation device 60 includes but is not limited to a processor 601 and a memory 602.

The memory 602 is configured to store executable instructions of the processor 601. It can be understood that the processor 601 is configured to execute the instructions to implement the point cloud data generation method in the embodiments described above.

It should be noted that a person skilled in the art may understand that the structure of the point cloud data generation device shown in FIG. 6 does not constitute a limitation on the point cloud data generation device. The point cloud data generation device may include more or fewer parts than those shown in FIG. 6, may combine some parts, or may have different part arrangements.

The processor 601 is a control center of the point cloud data generation device, and is connected to various parts of the entire point cloud data generation device by using various interfaces and lines. By running or executing software programs and/or modules stored in the memory 602, and calling data stored in the memory 602, various functions and data processing of the point cloud data generation device are executed, thereby performing overall monitoring on the point cloud data generation device. The processor 601 may include one or more processing units. Optionally, the processor 601 may integrate an application processor and a modem processor. The application processor mainly processes an operating system, a user interface, an application program, and the like, and the modem processor mainly processes wireless communications. It can be understood that the foregoing modem may not be integrated into the processor 601.

The memory 602 may be configured to store a software program and various data. The memory 602 may mainly include a program storage region and a data storage region. The program storage region may store an operating system, an application program (such as a determination unit and a processing unit) required by at least one functional module, and the like. In addition, the memory 602 may include a high-speed random access memory, and may further include a non-volatile memory, such as at least one magnetic disk storage device, a flash memory, or another volatile solid storage device.

In an exemplary embodiment, a computer-readable storage medium including instructions is further provided, such as the memory 602 including instructions. The above instructions are executable by the processor 601 of the point cloud data generation device 60 to implement the point cloud data generation method in the embodiments described above.

During actual implementation, the functions of the obtaining unit 501, the generation unit 502, the determination unit 503, and the processing unit 504 in FIG. 5 can all be achieved by the processor 601 in FIG. 6 calling the computer program stored in the memory 602. Specific execution processes of the functions can refer to the descriptions of the point cloud data generation method section in the embodiments described above, and will not be elaborated here.

Optionally, the computer-readable storage medium may be a volatile computer-readable storage medium. For example, the volatile computer-readable storage medium may be a read-only memory (ROM), a random access memory (RAM), a compact disc-ROM (CD-ROM), a magnetic tape, a floppy disk, an optical data storage device, or the like.

In an exemplary embodiment, the embodiments of the present application further provide a computer program product including one or more instructions. The one or more instructions can be executed by the processor 601 of the point cloud data generation device to complete the point cloud data generation method in the embodiments described above.

It should be noted that when the instructions in the computer-readable storage medium or the one or more instructions in the computer program product described above are executed by the processor of the point cloud data generation device, the various processes of the embodiments of the point cloud data generation method can be achieved, and the same technical effects as those of the point cloud data generation method can be achieved. To avoid repetitions, this will not be elaborated here.

Through the descriptions of the above implementations, a person skilled in the art can clearly know that for ease and simplicity of description, division of all the above functional modules is exemplified only. In practical applications, the foregoing functions may be allocated to be completed by different functional modules as required, that is, an inner structure of the apparatus is divided into different functional modules, so as to complete all or some of the functions described above.

In the several embodiments provided in the present application, it should be understood that the disclosed apparatus and method are achieved in other manners. For example, the above-described apparatus embodiments are merely illustrative. For example, the division of the modules or units is only one type of logical functional division, and other divisions is achieved in practice. For example, multiple units or components can be combined or integrated into another apparatus, or some features can be omitted, or not executed. In addition, the shown or discussed mutual coupling or direct coupling or communication connection is an indirect coupling or communication connection through some interfaces, apparatuses or units, and is in an electrical, mechanical or another form.

The units described as separate parts may or may not be physically separated, and parts displayed as units may or may not be one or a plurality of physical units, that is, may be located at one position, or may be distributed to a plurality of different places. Some or all of the units are selected according to actual needs to achieve the objectives of the solutions of this embodiment.

In addition, functional units in embodiments of the present application may be integrated into one processing unit, or each of the units may exist alone physically, or two or more units are integrated into one unit. The integrated unit may be implemented in a form of hardware, or may be implemented in a form of a software function unit.

When the integrated unit is implemented in the form of a software functional unit and sold or used as an independent product, the integrated unit may be stored in a readable storage medium. Based on this understanding, the technical solutions of the embodiments of the present application essentially, or the part that contributes to the prior art, or all or some of the technical solutions, can be reflected in the form of a software product. The software product is stored in a storage medium, including several instructions for causing a device (which may be a single-chip microcomputer, a chip, etc.) or a processor to execute all or some of the steps of the methods in the various embodiments of the present application. The aforementioned storage media include: various media that can store program codes, such as a USB flash disk, a mobile hard disk drive, a ROM, a RAM, a magnetic disk, and an optical disc.

The foregoing descriptions are merely specific implementations of the present application, but are not intended to limit the protection scope of the present application. Any change or substitution made within the technical scope disclosed in the present application shall fall within the protection scope of the present application. Therefore, the protection scope of the present application shall be subject to the protection scope of the claims.

## Claims

1. A point cloud data generation method, wherein the method comprises:
obtaining a first panoramic depth map corresponding to a target viewing angle in a simulation system, wherein the target viewing angle is a viewing angle, which is used for simulating a laser radar deployed in a vehicle in a real environment, in the simulation system;
generating, according to simulation parameters of an object in the first panoramic depth map and the first panoramic depth map, a feature map corresponding to the target viewing angle, wherein feature data comprised in the feature map is used for indicating simulation parameters corresponding to pixel points comprised in the first panoramic depth map; and
inputting the first panoramic depth map and the feature map corresponding to the target viewing angle to a target model to generate point cloud data corresponding to the target viewing angle.

2. The point cloud data generation method according to claim 1, wherein the feature map comprises at least one of an incident angle feature map, a reflection coefficient feature map, a first motion vector feature map, and a second motion vector feature map; the feature data comprised in the incident angle feature map is used for indicating an incident angle corresponding to the pixel points comprised in the first panoramic depth map; the feature data comprised in the reflection coefficient feature map is used for indicating a reflection coefficient corresponding to the pixel points comprised in the first panoramic depth map; the feature data comprised in the first motion vector feature map is used for indicating a speed corresponding to the pixel points comprised in the first panoramic depth map at a first moment; the feature data comprised in the second motion vector feature map is used for indicating a speed corresponding to the pixel points comprised in the first panoramic depth map at a second moment; and the second moment is a moment later than the first moment.

3. The point cloud data generation method according to claim 2, wherein in a case that the feature map comprises the incident angle feature map, the generating, according to simulation parameters of an object in the first panoramic depth map and the first panoramic depth map, a feature map corresponding to the target viewing angle comprises:
determining incident angle data of the object according to a position corresponding to the target viewing angle and a position simulation parameter of the object, wherein the incident angle data of the object is used for characterizing an incident angle of laser emitted from the position corresponding to the target viewing angle to the object; and
generating, according to the incident angle data of the object and a pixel coordinate system of the first panoramic depth map, the incident angle feature map corresponding to the target viewing angle, wherein each piece of feature data in the incident angle feature map is identified based on pixel coordinates.

4. The point cloud data generation method according to claim 2, wherein in a case that the feature map comprises the reflection coefficient feature map, the generating, according to simulation parameters of an object in the first panoramic depth map and the first panoramic depth map, a feature map corresponding to the target viewing angle comprises:
determining a reflection coefficient of the object according to a material simulation parameter of the object; and
generating, according to the reflection coefficient of the object and a pixel coordinate system of the first panoramic depth map, the reflection coefficient feature map corresponding to the target viewing angle, wherein each piece of feature data in the reflection coefficient feature map is identified based on pixel coordinates.

5. The point cloud data generation method according to claim 2, wherein in a case that the feature map comprises the first motion vector feature map, the generating, according to simulation parameters of an object in the first panoramic depth map and the first panoramic depth map, a feature map corresponding to the target viewing angle comprises:
generating, according to a speed simulation parameter of the object at the first moment and a pixel coordinate system of the first panoramic depth map, the first motion vector feature map corresponding to the target viewing angle, wherein each piece of feature data in the first motion vector feature map is identified based on pixel coordinates.

6. The point cloud data generation method according to claim 2, wherein in a case that the feature map comprises the second motion vector feature map, the generating, according to simulation parameters of an object in the first panoramic depth map and the first panoramic depth map, a feature map corresponding to the target viewing angle comprises:
generating, according to a speed simulation parameter of the object at the second moment and a pixel coordinate system of the first panoramic depth map, the second motion vector feature map corresponding to the target viewing angle, wherein each piece of feature data in the second motion vector feature map is identified based on pixel coordinates.

7. The point cloud data generation method according to any one of claims 1 to 6, wherein the inputting the first panoramic depth map and the feature map corresponding to the target viewing angle to a target model to generate point cloud data corresponding to the target viewing angle comprises:
inputting the first panoramic depth map and the feature map corresponding to the target viewing angle to the target model to obtain intensity information and depth information of a point cloud corresponding to the target viewing angle; and
generating, according to the intensity information and depth information of the point cloud corresponding to the target viewing angle, the point cloud data corresponding to the target viewing angle.

8. The point cloud data generation method according to claim 7, wherein the method further comprises:
obtaining operating data of a target vehicle in a first scenario, wherein the first scenario is a scenario in the real environment, and the operating data comprises driving data of the target vehicle and real point cloud data acquired by a laser radar of the target vehicle;
determining a second panoramic depth map and a feature map generated by a simulated vehicle driven with the driving data of the target vehicle in a second scenario, wherein the second scenario is a simulation scenario of the first scenario;
training a preset neural network by using the second panoramic depth map and the feature map as features and using the real point cloud data as a label to obtain the target model.

9. A point cloud data generation apparatus, comprising an obtaining unit and a generation unit, wherein
the obtaining unit is configured to obtain a first panoramic depth map corresponding to a target viewing angle in a simulation system, wherein the target viewing angle is a viewing angle, which is used for simulating a laser radar deployed in a vehicle in a real environment, in the simulation system;
the generation unit is configured to input the first panoramic depth map and a feature map corresponding to the target viewing angle to a target model to generate a feature map corresponding to the target viewing angle, wherein feature data comprised in the feature map is used for indicating simulation parameters corresponding to pixel points comprised in the first panoramic depth map; and
the generation unit is further configured to generate point cloud data corresponding to the target viewing angle according to the first panoramic depth map and the feature map.

10. The point cloud data generation apparatus according to claim 9, wherein the point cloud data generation apparatus further comprises a determination unit and a processing unit;
the obtaining unit is further configured to obtain operating data of a target vehicle in a first scenario, wherein the first scenario is a scenario in the real environment, and the operating data comprises driving data of the target vehicle and real point cloud data acquired by a laser radar of the target vehicle;
the determination unit is configured to determine a second panoramic depth map and a feature map generated by a simulated vehicle driven with the driving data of the target vehicle in a second scenario, wherein the second scenario is a simulation scenario of the first scenario; and
the processing unit is configured to train a preset neural network by using the second panoramic depth map and the feature map as features and using the real point cloud data as a label to obtain the target model, wherein the target model is configured to simulate, on the basis of the panoramic depth maps and the feature maps obtained in the simulation environment, point cloud data generated by the laser radar.

11. A point cloud data generation device, comprising a memory and a processor, wherein
the memory is coupled with the processor;
the memory is configured to store computer program codes; the computer program codes comprise computer instructions; and
when the processor executes the computer instructions, the point cloud data generation device performs the point cloud data generation method according to any one of claims 1 to 8.

12. A computer-readable storage medium, wherein the computer-readable storage medium stores instructions; and the instructions, when run on a point cloud data generation device, cause the point cloud data generation device to perform the point cloud data generation method according to any one of claims 1 to 8.
